# EUROPEAN PATENT APPLICATION

(11) **EP 1 973 141 A1**
(43) Date of publication of application: **24.09.2008**
(21) Application number: 07104546.2
(22) Date of filing: 21.03.2007
(51) Int. Cl.: H01J 37/34

(54) **Sputter cathode assembly and sputter coating device**

(71) Applicant: Applied Materials, Inc., Santa Clara, CA 95054 (US)
(72) Inventor: Gärtner, Harald, 61137 Schöneck (DE)
(74) Representative: Lermer, Christoph

(57) **Abstract**

A magnetron cathode assembly 1 according to the present invention comprises a drive shaft 2, one end 5 thereof being connected with a cathode/target assembly in the interior space 4 of a vacuum chamber. A housing 3 is rigidly mounted to the wall of a coating chamber of a sputter coating device by a flange 3a. Between the housing 3 and the drive shaft 2 a combined axial and radial bearing 1 l, e. g. a cross roller bearing, is arranged. The bearing supports the shaft 2 rotatably relative to the housing 3. By providing a combined axial and radial bearing 11 the installation space d of the assembly 1 may be reduced.

## Description

### TECHNICAL FIELD

The present invention relates to a sputter cathode assembly, particularly to a magnetron sputter cathode assembly, comprising at least one bearing system for rotatably supporting a rotatable cathode and/or target structure. Furthermore, the invention relates to a sputter coating device.

### BACKGROUND OF THE INVENTION

Sputtering is commonly used as a coating technology for coating substrates, e. g. large area glass substrates, within a vacuum chamber. In this process plasma is generated within an enclosed reaction chamber for depositing a thin film of target material on a stationary substrate or on a substrate that moves through the chamber and passes the target.

In order to increase the sputtering rate, magnetron sputtering has been developed which involves configuring an external magnet field to trap electrons in a region above the surface of the target/cathode. Thus an increased particle density may be generated. Furthermore, particles are sputtered from a substantially cylindrical rotatable target to improve the material usage of the target. Rotatable target tubes are available in different diameters and in a wide range of materials.

In large substrate coating devices quite long and heavy cathodes have to be provided. In order to support these cathodes various support constructions have been proposed, e.g. in document EP 1 355 343 A2 or US 5,096,562. Cantilever type supports as well as two-end type supports are known. The entire disclosure of both references is incorporated herein by reference.

In order to facilitate the rotation of the cathode/target, the cathode/target is supported by bearings. Usually a considerable number of bearings are arranged along the drive spindle extending from one or both sides of the cathode in order to provide sufficient and reliable support and positioning of the cathode. For example, at least two bearings are required to support the drive shaft and the cathode/target and to provide sufficient stability for the drive shaft in the radial direction and/or in the axial direction. However, most of the known constructions require considerable constructed space in order to fulfil the security, precision and reliability needs.

The bearings include journal and thrust bearings to support the drive shaft. For example, it is known to use single-ball bearings or double-ball bearings including an outer race, an inner race and one or two sets of balls positioned between the inner race and the outer race. The balls are circumferentially spaced relative to one another by a cage.

Above all, in most applications it is required to deposit a sufficiently homogeneous and uniform layer of coating material over the complete substrate surface. This may, however, be particularly critical in marginal areas of the surface of the substrate surface. Therefore, attempts have been made to increase the thickness of the target material at both ends of the target. Furthermore, targets having an excess length projecting over the edge of the substrate are provided.

As described above, conventional support constructions are quite complicated and require a lot of installation space, particularly in the longitudinal direction of the cathode.

### OBJECT OF THE INVENTION

It is an object of the present invention to provide a sputter cathode assembly and a sputter coating device having a rotatable cathode requiring reduced installation space, but without affecting precision and stability requirements.

### TECHNICAL SOLUTION

This object is achieved by providing a sputter cathode assembly according to claim 1 and a sputter coating device according to claim 10. The dependent claims refer to features of specific embodiments of the invention.

According to the invention a sputter cathode assembly, particularly a magnetron sputter cathode assembly, comprises at least one bearing system for rotatably supporting a rotatable cathode and/or target structure. The bearing system comprises at least one combined axial and radial bearing.

Said sputter cathode assembly is provided for a rotary cathode device having a rotary cathode and/or target structure, particularly a substantially cylindrical cathode and/or target.

Said sputter cathode assembly is characterized by a particular bearing system which is arranged between a stationary housing or fixed member and the rotatable cathode/target. The fixed member may be attached to the wall of a coating chamber.

The combined axial and radial bearing is a single bearing combining an axial bearing (thrust bearing) to withstand thrust, and a radial bearing (journal bearing) to withstand radial forces. The "combined" axial and radial bearing usually comprises one outer race component, one inner race component and a set of rollers, e. g. cylinders, arranged therebetween in a retainer structure. The rollers may be held in an annular cage arranged between the outer race and the inner race.

In conventional support units for magnetrons at least two bearings spaced along the rotation axis are provided for rotatably supporting the magnetron. Due to the installation of just one bearing instead of two or more bearings the construction may be small and compact. Thus the required installation space may be reduced. Furthermore, the inventor has found out that the stability and precision of a combined axial and radial bearing in a sputter coating device are even better than the stability and precision of two or more axially spaced thrust and/or journal bearings.

When arranging compact support units according to the invention within a coating chamber, the axial length of the target could be increased due to the shorter length of the support units. Therefore the excess length of the target exceeding the width of the substrate may be increased resulting in an improved uniformity of the coating in the marginal areas of the substrate surface.

Particularly, the combined axial and radial bearing is a cross(ed) roller bearing. In a cross(ed) roller bearing the (usually) elongated cylindrical rollers are crossed at a suitable angle, e. g. at a 90 ° angle, in an alternating fashion and enclosed between an inner race and an outer race.

The outer race may have a machined V-shaped grooved support and hold the rollers. The rollers may have, for example, a cross or "X"-configuration, which means that the angle of rotation of the cylinders define a cross or "X". The cross(ed) or "X"-type roller bearing provides high load-carrying capacities, can absorb great load impacts, and provides low-friction motion.

The cathode/target is rotatably supported by the cross roller bearing. The roller bearing carries the weight of the rotating cylindrical structure of the cathode/target irrespective of the orientation of the cathode.

Particularly, the sputter cathode assembly includes a rotatable cathode and/or target. The cathode generally comprises an elongated rotatable cylindrical tube having a target surface of sputter material. The cathode may be provided with an elongated magnet assembly (magnetron) inside the cathode. The magnet assembly is stationary while the target rotates. Furthermore, cooling means for cooling the cathode may be provided inside the tube.

A cathode potentially supplies to the rotatable cathode from a power source. An AC or DC power supply may supply the cathode with electrical power. The bearing configuration according to the invention may be installed in AC and DC rotatable magnetrons.

In a preferred embodiment the sputter cathode assembly may comprise a support unit comprising at least a housing or fixed member. The fixed member or housing is rigidly connected to the coating chamber wall. The support unit may also be an end block (e. g. a drive end block or a support end block).

In a preferred embodiment the cathode/target is connected with a drive shaft (spindle shaft). The drive shaft protrudes at one axial end or at two axial ends of the cathode. It may be driven by a drive means to rotate the cathode.

Particularly, the bearing is arranged between the drive shaft and the fixed member of said support unit. Usually the drive shaft is supported by the support unit with the bearing arranged between the stationary fixed member/housing and the drive shaft. The bearing supports the drive shaft as it rotates with the cathode. The conventional configuration of two bearings is replaced by a single bearing including a combined axial and radial bearing, e. g. a crossed roller bearing.

In a preferred embodiment means for driving said drive shaft to rotate said cathode/target are provided. The cathode/target is rotated by a drive system about its longitudinal axes. The drive means are operably connected with the target structure.

The support assembly may be configured to provide for a cantilever type mounting of the rotatable cathode. The first end of a rotatable cathode (particularly the corresponding drive shaft) is supported, while the second end is unsupported.

In another embodiment the support assembly is configured to provide a two-end support type mounting of the rotatable cathode. In this embodiment both ends of the cathode are supported by a combined axial and radial bearing. At least one of the ends, particularly both ends, is supported by at least one combined axial and radial bearing according to the invention. I a sputter device with a drop-in cathode (which is completely inserted in particular retainer constructions within the sputter chamber) vacuum space may be saved and the width of the target may be increased.

The obj ect of the invention is also solved by providing a sputter coating device including a coating chamber and a sputter cathode assembly as described above. Particularly, the sputter coating device is a magnetron sputtering apparatus.

A rotatable magnetron coating device usually comprises a vacuum sputtering chamber, a rotatable target arranged within the vacuum chamber, and a drive shaft connected with the target. The drive shaft may have a cylindrical shape and extend through an opening in the vacuum chamber wall. The drive shaft may be rotated by a suitable drive assembly. A seal between the vacuum chamber and the drive spindle may be constructed as a combination of a bearing and a seal. Ferrofluidic seals are known for sealing the interior of the vacuum chamber, e. g. by using a rotary vacuum feedthrough. The target is connected with the drive shaft for rotating therewith. In conventional device the target is supported by plurality of bearings arranged at least along a longitudinal portion of the drive shaft.

The present invention replaces the support assembly having a plurality of bearings with the inventive support assembly having at least one combined axial and radial bearing. Due to the fact that a single bearing is sufficient to support the rotatable cathode a cheap and space saving coating device can be provided.

The cathode/target may be supported in a horizontal, vertical or tilted orientation within the coating chamber. Whether the target is arranged and operated in a horizontal, vertical or inclined position depends on the application and on the construction of the coatings device.

With the present invention, a compact and stable support construction for rotatably supporting a cathode/target may be obtained.

### BRIEF DESCRIPTION OF THE DRAWINGS

Further features and advantages of the invention are apparent from the following description of preferred embodiments using the enclosed drawings. The figures show in
- Fig. 1: a partially sectional view of a conventional magnetron cathode assembly;
- Fig. 2: a partially sectional view of a magnetron cathode assembly according to the present invention;
- Fig. 3: a sectional side view of a vacuum chamber with various arrangements of the magnetron cathode assembly according to the present invention;
- Fig. 4: a sectional view of a conventional sputter coating device;
- Fig. 5: a sectional view of a sputter coating device according to the present invention;
- Fig. 6: a schematic illustration of a bearing construction used in conventional magnetron cathode assemblies;
- Fig. 7: a schematic illustration of a bearing construction used in a magnetron cathode assembly according to the present invention; and in
- Fig. 8: an illustration of a bearing used in the magnetron cathode assembly according to the invention.

### DESCRIPTION OF SPECIFIC EMBODIMENTS OF THE INVENTION

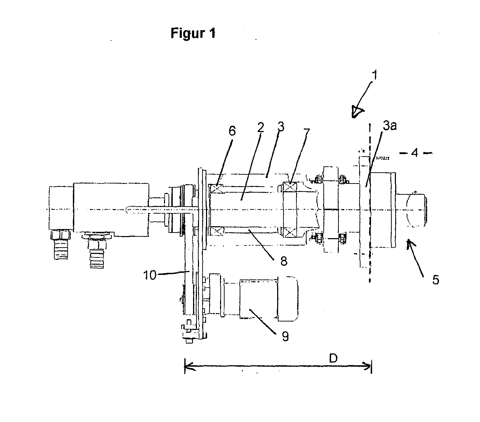

Fig. 1 illustrates a conventional magnetron cathode assembly 1. The magnetron cathode assembly 1 includes a drive shaft 2 that extends into the interior 4 of a vacuum chamber. The vacuum chamber wall is schematically indicated by a dashed line. The housing or fixed member 3 of the assembly 1 is rigidly attached to a vacuum chamber by attaching a mounting flange 3a to a wall of the vacuum chamber. A sealing is provided for sealing the interior 4 of the vacuum chamber to maintain vacuum pressure inside during the coating process.

At the end 5 extending into the interior 4 of the vacuum chamber the drive shaft 2 comprises a mounting portion which is rigidly connected with the cathode/target so that the cathode/target may be rotated together with the drive shaft 2. The drive shaft 2 may be rotated by a drive 9. The torque of the drive 9 is transmitted to the drive shaft 2 by means of a drive belt 10, a chain and/or a gearing (not shown).

The drive shaft 2 is rotatably supported in the housing 3 of the assembly 1 by a first conventional roller bearing 6 and a second conventional roller bearing 7. The bearings 6 and 7 are spaced apart along the axial direction of the drive shaft 2. Between the bearings 6 and 7 there may be provided a spacing member 8 in order to secure a proper spacing between the bearings 6 and 7.

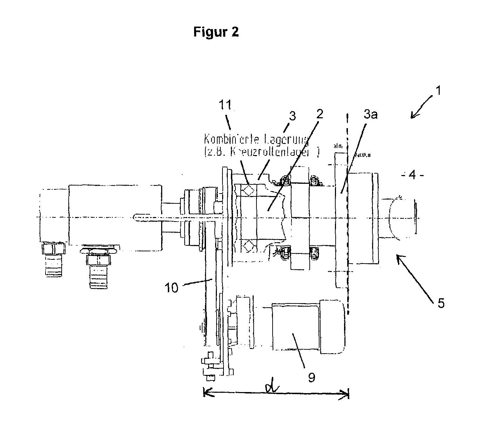

Fig. 2 illustrates a magnetron cathode assembly 1 according to the present invention, wherein parts corresponding to parts of the conventional cathode assembly illustrated in Fig. 1 are designated with the same reference numerals.

The magnetron cathode assembly 1 according to the present invention comprises a drive shaft 2. One end 5 thereof may be connected with a cathode/target assembly in the interior space 4 of a vacuum chamber.

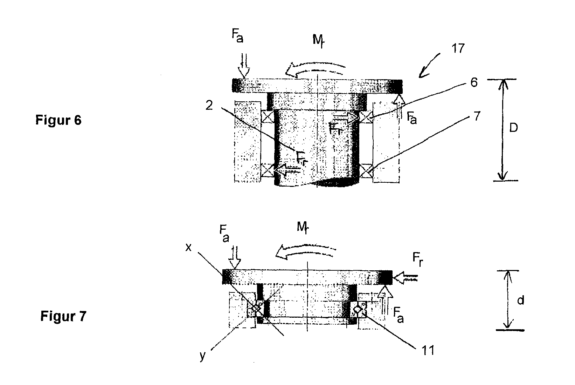

According to the invention, instead of using at least two conventional roller bearings spaced apart along the longitudinal axis of the drive shaft 2, a combined radial and axial bearing (combined journal bearing and thrust bearing) 11 supports the drive shaft 2 in a housing 3 which is rigidly fixed to a chamber wall of the vacuum chamber of the coating device by a mounting flange 3a. The bearing supports the shaft 2 rotatably relative to the housing 3. Particularly, a cross roller bearing 11 is used for supporting the cathode/target structure. A specific cross roller bearing is described below and illustrated in Fig. 7.

Due to the fact that a single bearing 11 replaces two conventional bearings 6 and 7 or even a plurality of bearings, the longitudinal distance between the chamber wall and the drive unit 9, 10 could be considerably reduced from a distance D in the conventional assembly (cf. Fig. 1) to a smaller distance d in the assembly according to the invention (cf. Fig. 2). Thus, the required installation space could be reduced accordingly.

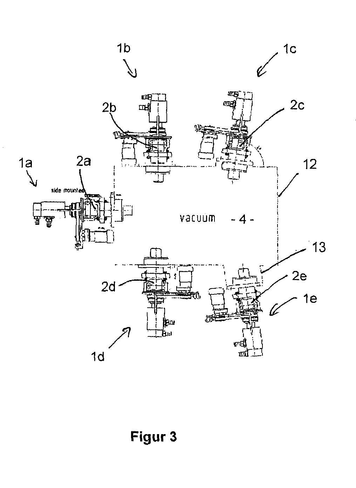

When using a cross roller bearing that may resist axial forces (in the direction of the longitudinal axis of the cylindrical cathode) as well as radial forces in a magnetron sputtering device there are various possibilities to arrange the inventive magnetron cathode assembly 1 at a vacuum chamber wall 12 as illustrated in Fig. 3. A first magnetron cathode assembly 1a is side mounted at the vacuum chamber wall 12. The longitudinal axis of the drive shaft 2a is arranged horizontally.

The magnetron sputter arrangements 1b and 1c are mounted at the top wall 12 of the vacuum chamber. Whereas the second drive shaft 2b is arranged vertically, the longitudinal axis of the third drive shaft 2c includes an acute angle with the top wall of the vacuum chamber (i.e. with the horizontal line).

The magnetron sputter arrangements 1d and 1e are mounted at the bottom wall 12 of the coating chamber wherein the longitudinal axis of the fourth drive shaft 2d is arranged vertically and the longitudinal axis of the fifth drive shaft 2e includes an acute angle with the bottom wall of the vacuum chamber (i.e. with the horizontal line). For mounting the assembly 1e a particular connecting piece 13 is provided at the vacuum chamber wall 12.

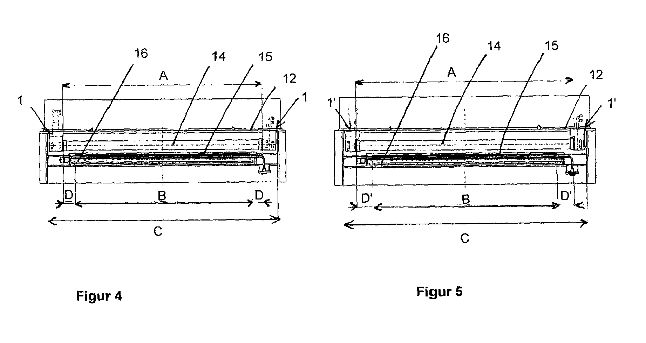

Figs. 4 and 5 illustrate respective sectional views of a sputter coating device having a rotary cathode/target 14 of a "drop-in" type in a sectional view perpendicular to the transport direction of a substrate 15. Fig. 4 shows a conventional coating device, whereas Fig.5 illustrates a coating device according to the present invention.

In both embodiments a rotatable (magnetron) cathode/target 14 is provided within a sputter coating chamber 12 of e.g. a class coating device. A substrate 15 having a defined width indicated by distance arrow B is arranged on a transport mechanism, e. g. rollers 16, and transported through the vacuum chamber 12 to pass the cathode/target 14 in order to be coated.

While a cantilever type mounting of the rotatable cathode is possible, in the embodiments of Figs. 4 and 5 the first end and the second end of the cathode 14 are supported by respective cathode support structures 1 and 1', respectively. At least one of the cathode support structures 1 and 1' may comprise a bearing structure, particularly each of the cathode support structures 1 or 1' (i.e. at least one bearing structure on either side). Whereas the conventional sputtering device comprises conventional bearing arrangements, the sputtering device according to the invention comprises at least one cross ("X"-) bearing device, particularly exactly one cross ("X"-) bearing device, or exactly one cross ("X"-) bearing device on either side of the cathode.

When using the magnetron cathode arrangement 1 as shown in Fig. 4 the total width of the chamber indicated as C allows an excess length D of the cathode/target 14 extending over the side edge of the substrate 15 on both sides of the substrate 15. This excess length D is limited by the construction length of the conventional magnetron sputter arrangement 1 which has to be accommodated within the coating chamber 12 in the "drop-in" type coating device.

Fig. 5 shows that the inventive magnetron sputter arrangements 1' having a shorter construction length (cf. also Figs. 1 and 2) provide for a excess length D' larger than the excess length D which is provided for in a comparable coating system using conventional magnetron cathode arrangements 1. In a number of applications, however, an increase in the excess length D' improves the quality of the coating layer, particularly near the side edges of the substrates 15.

Fig. 6 illustrates a schematic view of a bearing system 17 according to the state of the art. The bearing system 17 includes two bearings 6 and 7 and a drive shaft 2 which is rotatably supported by the bearing system 17. The bearings 6 and 7 are, for example, conventional single-ball or two-ball bearings.

As indicated by the arrows Fᵣ and Fₐ the bearing system 17 may withstand radial forces Fᵣ and axial forces Fₐ. The rotation of the shaft 2 is indicated by the arrow Mᵣ.

The installation length of the bearing system 17 is indicated with the arrow D.

Fig. 7 shows a bearing system having combined radial and axial bearings 11, e. g. a cross roller bearing which may withstand radial and axial forces. Thus, a shorter installation length indicated by arrow d may be implemented. Radial and axial forces Fᵣ and Fₐ are both absorbed by the combined bearing 11.

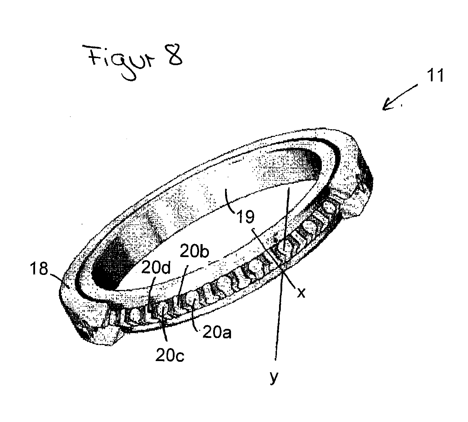

Fig. 8 illustrates a cross roller bearing 11 as an example of a combined axial and radial bearing. It comprises an outer race (outer ring) 18, an inner race (inner ring) 19 and a plurality of cylindrical rollers 20a, 20b, 20c, 20d,... arranged between the outer race 18 and the inner race 19. The rollers are generally arranged in a respective retainer, e.g. spaced by spacers (e.g. made of plastic material) arranged between the rollers 20a, 20b, 20c, 20d, ... or provided in a cage.

The rotational axes y of a first plurality of rollers 20a, 20c, ... are arranged on a cone-shaped surface, and the rotational axes x of a second plurality of cylindrical rollers 20b, 20d, ... are arranged on a second cone-shaped surface. The first and second cone-shaped surfaces include an angle, e. g. 90 °. The cylindrical rollers of the first plurality of rollers 20a, 20c, ... are interposed between cylindrical rollers of the second plurality of rollers 20b, 20d, ... In other words, the rollers of the first plurality of rollers 20a, 20c, ... and the rollers of the second plurality of rollers 20b, 20d,... are alternately circumferentially arranged between the outer race 18 and the inner race 19 of the bearing 11. The rollers of the first plurality of rollers and the second plurality of rollers are crossed (e.g. at a 90° angle) in an alternating fashion.

The outer race 18 has a machined V-shaped groove to support the rollers. In the embodiment the outer race is comprised of two parts and fixed by suitable retainers (not shown). The outer race 18 and the inner race 19 function as a rail that enclose the rollers 20a, 20b, 20c, 20d,...

Due to the cross-type arrangement of the rollers 20a, 20b, 20c, 20d, respectively, the bearing 11 may withstand an axial load from both sides, a radial load, torque, tilting and combinations of these loads in a single bearing. Thus, the conventional construction including two spaced bearings can be reduced to a single bearing. Furthermore, it has been recognised that combined bearings are characterized by large stiffness and a high running precision.

## Claims

1. A Sputter cathode assembly (1), particularly a magnetron sputter cathode assembly, comprising at least one bearing system for rotatably supporting a rotatable cathode and/or target structure (14),
**characterized in that**
said bearing system comprises at least one combined axial and radial bearing (11).

2. The sputter cathode assembly (1) according to claim 1, wherein
said combined axial and radial bearing (11) comprises a cross(ed) roller bearing.

3. The sputter cathode assembly (1) according to any of the previous claims 1 or 2, wherein
said sputter cathode assembly (1) comprises at least one rotatable cathode and/or target (14).

4. The sputter cathode assembly (1) according to any of the previous claims, wherein said sputter cathode assembly (1) comprises a support assembly having at least a fixed member (3, 3a).

5. The sputter cathode assembly (1) according to any of the previous claims 3 or 4, wherein
said rotatable cathode and/or target (14) is connected with a drive shaft (2).

6. The sputter cathode assembly (1) according to claim 5, wherein
said combined axial and radial bearing (11) is arranged between said drive shaft (2) and said fixed member (3) of said support assembly.

7. The sputter cathode assembly (1) according to any of the previous claims 5 or 6, wherein
said sputter cathode assembly (1) comprises means for driving said drive shaft (2) to rotate said cathode and/or target structure.

8. The sputter cathode assembly (1) according of any of the previous claims, wherein said sputter cathode assembly (1) is configured to provide for a cantilever type mounting of the rotatable cathode/target structure (14).

9. The sputter cathode assembly (1) according to any of the previous claims 1 to 7, wherein
said sputter cathode assembly (1) is configured to provide for a two-end support type mounting of the rotatable cathode/target structure (14).

10. A sputter coating device, comprising:
at least one coating chamber (12), and
a sputter cathode assembly (1) according to any of the previous claims.

11. A sputter coating device according to claim 10, wherein
said rotatable cathode and/or target structure (14) is supported in a horizontal, in a vertical or in a tilted orientation.
